# EUROPEAN PATENT APPLICATION

(11) **EP 4 727 315 A1**
(43) Date of publication of application: **15.04.2026**
(21) Application number: 24819532.3
(22) Date of filing: 29.05.2024
(51) Int. Cl.: H10K 59/80, H10K 59/122, H10K 59/38, B60K 35/00, H10K 102/00

(54) **DISPLAY DEVICE FOR VEHICLE AND VEHICLE COMPRISING SAME**

(30) Priority: 08.06.2023 KR 20230073397
(71) Applicant: Samsung Display Co., Ltd., Yongin-si, Gyeonggi-do 17113 (KR)
(72) Inventor: LEE, Jung Wook, Yongin-si Gyeonggi-do 17113 (KR)
(74) Representative: Marks & Clerk LLP
(86) International application number: PCT/KR2024/007337
(87) International publication number: WO 2024/253380

(57) **Abstract**

A display device for a vehicle, according to an embodiment, includes: a substrate; a light-emitting element layer disposed on the substrate and comprising a pixel electrode, an organic film layer, and a common electrode; a pixel defining film disposed on the substrate and comprising a plurality of openings exposing a portion of the pixel electrode; an encapsulation layer disposed on the light-emitting element layer; a metal oxide layer disposed on the encapsulation layer and overlapping the pixel defining layer; a light shielding layer disposed on the metal oxide layer and overlapping the metal oxide layer; and a color filter layer disposed over the light shielding layer and the encapsulation layer.

## Description

### [TECHNICAL FIELD]

The present disclosure relates to a display device for a vehicle and a vehicle including the same.

### [BACKGROUND ART]

As an information society develops, the demand for a display device for displaying an image is increasing in various forms. The display device may be a flat panel display, such as a liquid crystal display, a field emission display, or a light emitting display panel. The light emitting display device may include an organic light emitting diode display device including an organic light emitting diode element as a light emitting element or a light emitting diode display device including an inorganic light emitting diode element such as a light emitting diode (LED) as a light emitting element.

A display device for a vehicle may include a polarizing plate for preventing out-gassing of an organic film inside the display device due to ultraviolet rays incident from the outside. The polarizing plate may be attached to an outer surface of the display device, but manufacturing cost and time required for attaching the polarizing plate may reduce productivity. Therefore, research on a display device for a vehicle capable of omitting the polarizing plate is continuously being conducted.

### [DISCLOSURE]

### [TECHNICAL PROBLEM]

Aspects of the present disclosure provide a display device for a vehicle capable of omitting a polarizing plate and blocking ultraviolet rays and a vehicle including the same.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### [TECHNICAL SOLUTION]

According to an aspect of the present disclosure, a display device for a vehicle comprises a substrate, a light emitting element layer disposed on the substrate and including a pixel electrode, an organic layer, and a common electrode, a pixel defining layer disposed on the substrate and including a plurality of openings exposing a portion of the pixel electrode, an encapsulation layer disposed on the light emitting element layer, a metal oxide layer disposed on the encapsulation layer and overlapping the pixel defining layer, a light blocking layer disposed on the metal oxide layer and overlapping the metal oxide layer, and a color filter layer disposed on the light blocking layer and the encapsulation layer.

The metal oxide layer may be in contact with an upper surface of the encapsulation layer and a lower surface of the light blocking layer.

The metal oxide layer may include any one or more selected from titanium oxide, zinc oxide, and tantalum oxide.

The metal oxide layer may have a thickness of 10 to 10000 nm.

The metal oxide layer may include a plurality of opening holes overlapping the plurality of openings.

A size of the opening hole of the metal oxide layer may be the same as a size of the opening of the pixel defining layer.

A size of the opening hole of the metal oxide layer may be greater than a size of the opening of the pixel defining layer, and a width of the metal oxide layer may be smaller than a width of the pixel defining layer.

A side of the metal oxide layer may be disposed inward more than a side of the light blocking layer, and the light blocking layer may cover an upper surface and the side of the metal oxide layer.

The light blocking layer may include a plurality of holes overlapping the plurality of openings, and the size of the opening hole of the metal oxide layer may be greater than a size of the hole of the light blocking layer.

The light blocking layer may include a plurality of holes overlapping the plurality of openings, and the size of the opening hole of the metal oxide layer may be smaller than a size of the hole of the light blocking layer.

A side of the metal oxide layer may protrude outward more than a side of the light blocking layer, and a width of the metal oxide layer may be greater than a width of the light blocking layer.

The light blocking layer may include a plurality of holes overlapping the plurality of openings, and the size of the opening hole of the metal oxide layer may be the same as a size of the hole of the light blocking layer.

A side of the metal oxide layer may be aligned and matched with a side of the light blocking layer.

The pixel defining layer may include a plurality of pixel openings disposed between the pixel electrodes, and the light blocking layer may include a plurality of pattern openings overlapping the plurality of pixel openings.

A side of the metal oxide layer may be aligned and matched with a side of the pixel defining layer, and a width of the metal oxide layer may be the same as a width of the pixel defining layer.

According to an aspect of the present disclosure, a vehicle includes a dashboard and a display device for a vehicle that is disposed on the dashboard to display information, wherein the display device for a vehicle includes a substrate, a light emitting element layer disposed on the substrate and including a pixel electrode, an organic layer, and a common electrode, a pixel defining layer disposed on the substrate and including a plurality of openings exposing a portion of the pixel electrode, an encapsulation layer disposed on the light emitting element layer, a metal oxide layer disposed in the encapsulation layer and overlapping the pixel defining layer, a light blocking layer disposed on the encapsulation layer and overlapping the metal oxide layer, and a color filter layer disposed on the light blocking layer and the encapsulation layer.

The encapsulation layer may include a first encapsulation layer disposed on the light emitting element layer, a second encapsulation layer disposed on the first encapsulation layer, and a third encapsulation layer disposed on the second encapsulation layer.

The metal oxide layer may be disposed between the second encapsulation layer and the third encapsulation layer.

The metal oxide layer may be disposed between the first encapsulation layer and the second encapsulation layer.

The metal oxide layer may include any one or more selected from titanium oxide, zinc oxide, and tantalum oxide.

Other features and embodiments may be apparent from the following detailed description and the drawings.

### [ADVANTAGEOUS EFFECTS]

According to the display device for a vehicle and a vehicle including the same according to an embodiment, by disposing a metal oxide layer that absorbs light in an ultraviolet wavelength band between an encapsulation layer and a light blocking layer, it is possible to reduce the light in the ultraviolet wavelength band incident from the outside reaching a pixel defining layer. Accordingly, deterioration of the organic layer and oxidation of the common electrode caused by out-gassing of the pixel defining layer may be reduced, thereby reducing pixel shrinkage.

The effects according to the embodiments are not limited by the contents exemplified above, and more various effects are included in this disclosure.

### [DESCRIPTION OF DRAWINGS]

FIG. 1 is a perspective view illustrating a display device according to an embodiment;
FIG. 2 is a cross-sectional view of the display device of FIG. 1 viewed from a side;
FIG. 3 is a plan view illustrating a display layer of the display device according to an embodiment;
FIG. 4 is a plan view illustrating a display area of a display panel according to an embodiment;
FIG. 5 is an enlarged plan view of area A of FIG. 4;
FIG. 6 is a cross-sectional view taken along line X1-X1' of FIG. 5;
FIG. 7 is a schematic view illustrating an incident path of external light;
FIG. 8 is a plan view illustrating pixels according to another embodiment;
FIG. 9 is a cross-sectional view taken along line X2-X2' of FIG. 8;
FIG. 10 is a plan view illustrating pixels according to still another embodiment;
FIG. 11 is a cross-sectional view taken along line X3-X3' of FIG. 10;
FIG. 12 is a cross-sectional view illustrating a display device according to still another embodiment;
FIG. 13 is a cross-sectional view illustrating a display device according to still another embodiment;
FIG. 14 is a cross-sectional view illustrating each light emitting area of the display device according to an embodiment;
FIG. 15 is a plan view illustrating each light emitting area of the display device according to an embodiment;
FIG. 16 is a cross-sectional view taken along line X4-X4' of FIG. 15;
FIG. 17 is a cross-sectional view illustrating a portion of a pixel opening of the display device according to an embodiment; and
FIG. 18 is a schematic view when the display device according to an embodiment is applied to a vehicle.

### [MODES OF THE INVENTION]

The advantages and features of the present invention, and the methods for achieving them, will become apparent with reference to the embodiments described in detail below together with the accompanying drawings. However, the present invention is not limited to the embodiments disclosed hereinafter but will be embodied in various different forms, and these embodiments are merely provided so that the disclosure of the present invention is complete and to fully inform those skilled in the art to which the present invention pertains of the scope of the invention, and the present invention is defined by the scope of the claims.

When an element or a layer is referred to as being "on" another element or layer, this includes both a case where it is directly on the other element, and a case where another layer or element is interposed therebetween. Likewise, references to "below," "left," and "right" of another element also include both cases where they are directly adjacent and cases where another layer or material is interposed therebetween. Throughout the specification, the same reference numerals refer to the same components.

Although terms such as first, second, etc. are used to describe various components, these components are not limited by these terms. These terms are merely used to distinguish one component from another. Thus, a first component mentioned below may also be a second component within the technical spirit of the present invention.

Hereinafter, embodiments of the present disclosure will be described with reference to the drawings.

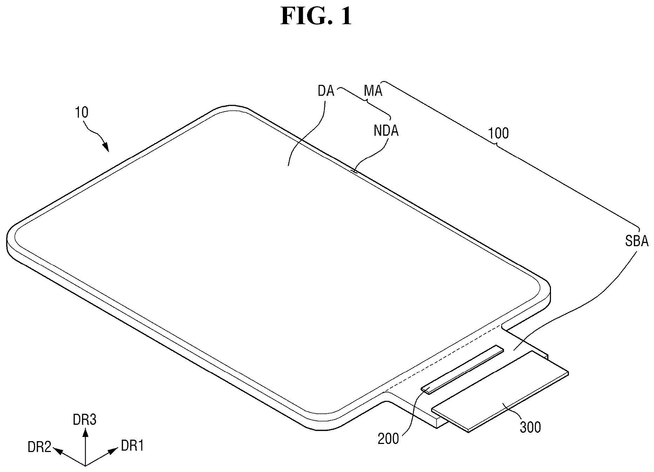

FIG. 1 is a perspective view illustrating a display device according to an embodiment.

Referring to FIG. 1, a display device 10 may display a moving image or a still image. The display device 10 may refer to any electronic device that provides a display screen. For example, the display device 10 may include televisions, laptop computers, monitors, billboards, Internet of things, mobile phones, smartphones, tablet personal computers (PCs), electronic watches, smartwatches, watch phones, head mounted displays, mobile communication terminals, electronic notebooks, electronic books, portable multimedia players (PMPs), navigation, game consoles, digital cameras, camcorders, vehicle navigation, vehicle dashboards, and the like that provide a display screen. In the present specification, the display device 10 may be a display device for a vehicle that may be provided in a vehicle, but is not limited thereto.

Examples of the display device 10 may include an inorganic light emitting diode display device, an organic light emitting display device, a quantum dot light emitting display device, a plasma display device, and a field emission display device. Hereinafter, it is illustrated that an organic light emitting diode display device is used as an example of the display device, but the present disclosure is not limited thereto and may also be applied to other display devices as long as the same technical idea is applicable thereto.

A shape of the display device 10 may be variously changed. For example, the display device 10 may have a shape similar to a quadrangle having a side in a first direction DR1 and a side in a second direction DR2. A corner where the side in the first direction DR1 and the side in the second direction DR2 meet may be rounded to have a curvature, but is not limited thereto and may also be formed at a right angle. The planar shape of the display device 10 is not limited to the quadrangle, and may be formed similarly to other polygons, circles, or ovals.

The display device 10 may include a display area DA and a non-display area NDA. The display area DA is an area in which a screen may be displayed, and the non-display area NDA is an area in which a screen is not displayed. The display area DA may also be referred to as an active area, and the non-display area NDA may also be referred to as a non-active area. The display area DA may generally occupy the center of the display device 10.

The display device 10 includes a display panel 100, a display driver 200, a circuit board 300, and a touch driver 400.

The display panel 100 may include a main area MA and a sub-area SBA.

The main area MA may include a display area DA including pixels displaying an image, and a non-display area NDA disposed around the display area DA. The display area DA may emit light from a plurality of light emitting areas or a plurality of opening areas. For example, the display panel 100 may include a pixel circuit including switching elements, a pixel defining layer defining the light emitting areas or the opening areas, and a self-light emitting element.

For example, the self-light emitting element may include at least one of an organic light emitting diode (OLED) including an organic light emitting layer, a quantum dot LED including a quantum dot light emitting layer, an inorganic LED including an inorganic semiconductor, and a micro LED, but is not limited thereto.

The non-display area NDA may be an area outside the display area DA. The non-display area NDA may be defined as an edge area of the main area MA of the display panel 100. The non-display area NDA may include a gate driver (not illustrated) supplying gate signals to gate lines, and fan-out lines (not illustrated) connecting the display driver 200 and the display area DA.

The sub-area SBA may be an area extending from one side of the main area MA. The sub-area SBA may include a flexible material that may be bent, folded, rolled, or the like. For example, when the sub-area SBA is bent, the sub-area SBA may overlap the main area MA in a thickness direction (a third direction DR3). The sub-area SBA may include the display driver 200 and a pad portion connected to the circuit board 300. In another embodiment, the sub-area SBA may be omitted, and the display driver 200 and the pad portion may be disposed in the non-display area NDA.

The display driver 200 may output signals and voltages for driving the display panel 100. The display driver 200 may supply data voltages to the data lines. The display driver 200 may supply a power voltage to the power line and may supply a gate control signal to the gate driver. The display driver 200 may be formed as an integrated circuit (IC) and mounted on the display panel 100 by a chip on glass (COG) method, a chip on plastic (COP) method, or an ultrasonic bonding method. For example, the display driver 200 may be disposed in the sub-area SBA, and may overlap the main area MA in the thickness direction by bending of the sub-area SBA. As another example, the display driver 200 may be mounted on the circuit board 300.

The circuit board 300 may be attached onto the pad portion of the display panel 100 using an anisotropic conductive film (ACF). Lead lines of the circuit board 300 may be electrically connected to the pad portion of the display panel 100. The circuit board 300 may be a flexible film such as a flexible printed circuit board, a printed circuit board, or a chip on film.

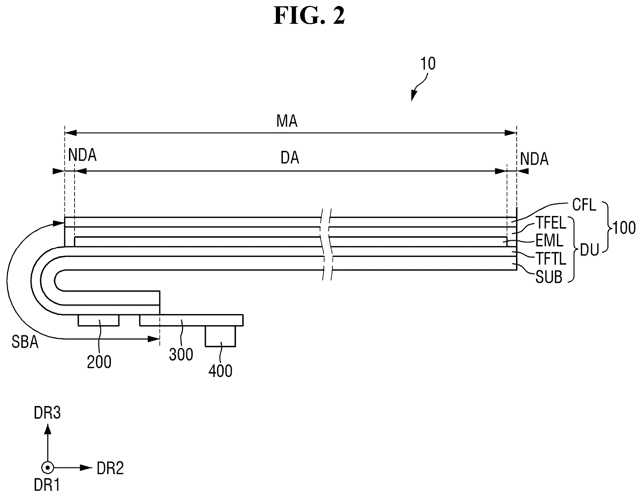

FIG. 2 is a cross-sectional view of the display device of FIG. 1 viewed from a side.

Referring to FIG. 2, the display panel 100 may include a display layer DU and a color filter layer CFL. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate that may be bent, folded, rolled, or the like. For example, the substrate SUB may include a polymer resin such as polyimide PI, but is not limited thereto. In another embodiment, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include gate lines, data lines, power lines, gate control lines, fan-out lines connecting the display driver 200 and the data lines, and lead lines connecting the display driver 200 and the pad portion. Each of the thin film transistors may include a semiconductor area, a source electrode, a drain electrode, and a gate electrode. For example, when the gate driver is formed on one side of the non-display area NDA of the display panel 100, the gate driver may include the thin film transistors.

The thin film transistor layer TFTL may be disposed in the display area DA, the non-display area NDA, and the sub-area SBA. The thin film transistors, the gate lines, the data lines, and the power lines of each of the pixels of the thin film transistor layer TFTL may be disposed in the display area DA. The gate control lines and the fan-out lines of the thin film transistor layer TFTL may be disposed in the non-display area NDA. The lead lines of the thin film transistor layer TFTL may be disposed in the sub-area SBA.

The light emitting element layer EML may be disposed on the thin film transistor layer TFTL. The light emitting element layer EML may include a plurality of light emitting elements including a first electrode, a second electrode, and a light emitting layer to emit light, and a pixel defining layer defining pixels. The plurality of light emitting elements of the light emitting element layer EML may be disposed in the display area DA.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives a cathode voltage, holes and electrons may move to the organic light emitting layer through the hole transporting layer and the electron transporting layer, respectively, and may be combined with each other in the organic light emitting layer to emit light.

In another embodiment, the light emitting element may include a quantum dot light emitting diode including a quantum dot light emitting layer, an inorganic light emitting diode including an inorganic semiconductor, or a micro light emitting diode.

An encapsulation layer TFEL may cover an upper surface and side surfaces of the light emitting element layer EML, and may protect the light emitting element layer EML. The encapsulation layer TFEL may include at least one inorganic film and at least one organic film for encapsulating the light emitting element layer EML.

The color filter layer CFL may be disposed on the encapsulation layer TFEL. The color filter layer CFL may include a plurality of color filters corresponding to each of the plurality of light emitting areas. Each of the color filters may selectively transmit light of a specific wavelength and block or absorb light of a different wavelength. The color filter layer CFL may absorb a portion of light introduced from the outside of the display device 10 to reduce reflected light caused by external light. Therefore, the color filter layer CFL may prevent color distortion caused by reflection of external light.

As the color filter layer CFL is directly disposed on the encapsulation layer TFEL, the display device 10 may not require a separate substrate for the color filter layer CFL. Therefore, the display device 10 may have a relatively small thickness.

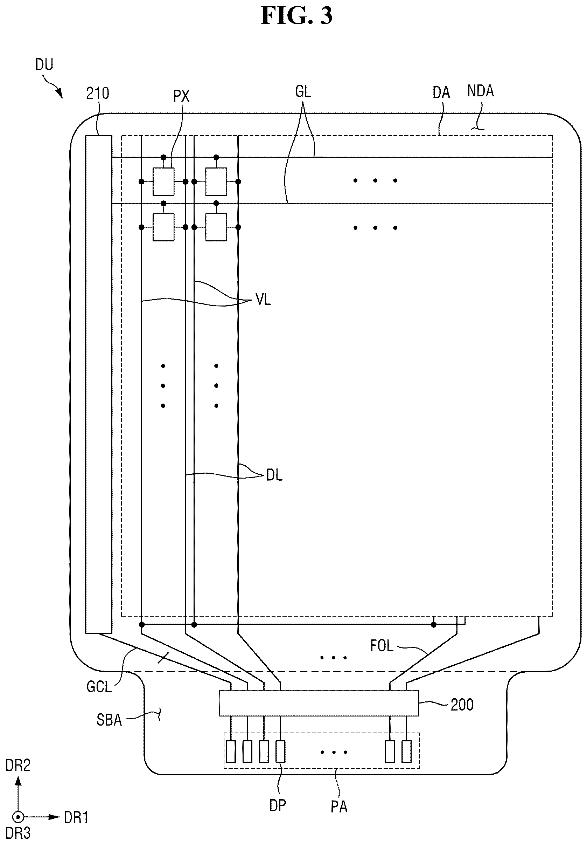

FIG. 3 is a plan view illustrating a display layer of the display device according to an embodiment.

Referring to FIG. 3, the display layer DU may include a display area DA and a non-display area NDA.

The display area DA may be disposed at a center of the display panel 100. A plurality of pixels PX, a plurality of gate lines GL, a plurality of data lines DL, and a plurality of power lines VL may be disposed in the display area DA. Each of the plurality of pixels PX may be defined as a minimum unit emitting light.

The plurality of gate lines GL may supply a gate signal received from a gate driver 210 to the plurality of pixels PX. The plurality of gate lines GL may extend in the first direction DR1 and may be spaced apart from each other in the second direction DR2 intersecting the first direction DR1.

The plurality of data lines DL may supply the data voltage received from the display driver 200 to the plurality of pixels PX. The plurality of data lines DL may extend in the second direction DR2 and may be spaced apart from each other in the first direction DR1.

The plurality of power lines VL may supply the power voltage received from the display driving unit 200 to the plurality of pixels PX. Here, the power voltage may be at least one of a driving voltage, an initialization voltage, a reference voltage, and a low potential voltage. The plurality of power lines VL may extend in the second direction DR2 and may be spaced apart from each other in the first direction DR1.

The non-display area NDA may surround the display area DA. The gate driver 210, fan-out lines FOL, and gate control lines GCL may be disposed in the non-display area NDA. The gate driver 210 may generate a plurality of gate signals based on the gate control signal, and may sequentially supply the plurality of gate signals to the plurality of gate lines GL according to a set order.

The fan-out lines FOL may extend from the display driver 200 to the display area DA. The fan-out lines FOL may supply the data voltages received from the display driver 200 to the plurality of data lines DL.

The gate control line GCL may extend from the display driver 200 to the gate driver 210. The gate control line GCL may supply the gate control signal received from the display driver 200 to the gate driver 210.

The sub-area SBA may include a display driver 200, a pad area PA, and first and second touch pad areas TPA1 and TPA2.

The display driver 200 may output signals and voltages for driving the display panel 100 to the fan-out lines FOL. The display driver 200 may supply the data voltage to the data lines DL through the fan-out lines FOL. The data voltage may be supplied to the plurality of pixels PX and may control luminance of the plurality of pixels PX. The display driver 200 may supply the gate control signal to the gate driver 210 through the gate control line GCL.

The pad area PA may be disposed at an edge of the sub-area SBA. The pad area PA may be electrically connected to the circuit board 300 using a material such as an anisotropic conductive film or self assembly anisotropic conductive paste (SAP). The pad area PA may include a plurality of display pad portions DP. The plurality of display pad portions DP may be connected to a graphic system through the circuit board 300. The plurality of display pad portions DP may be connected to the circuit board 300 to receive digital video data, and may supply the digital video data to the display driver 200.

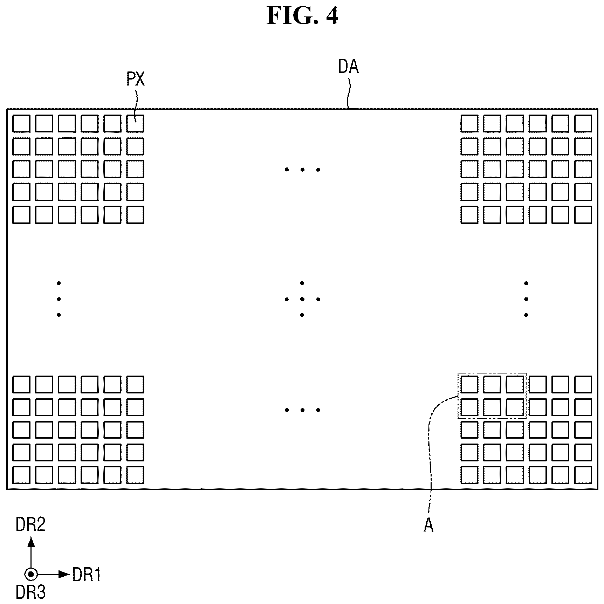

FIG. 4 is a plan view illustrating a display area of a display panel according to an embodiment.

Referring to FIG. 4, the display panel 100 may include a plurality of pixels PX arranged in the first and second directions DR1 and DR2. Each of the pixels PX may have a planar shape such as a rectangle, a square, or a rhombus. For example, as illustrated in the drawing, each of the pixels PX may have a planar shape such as a square. However, each of the pixels PX is not limited thereto, and may have various shapes such as a polygon, a circle, and an ellipse in plan view.

Some of the pixels PX may emit first light, others of the pixels PX may emit second light, and the rest of the pixels PX may emit third light. Here, the first light may be light in a blue wavelength band, the second light may be light in a red wavelength band, and the third light may be light in a green wavelength band. The red wavelength band may be a wavelength band of approximately 600 nm to 750 nm, the green wavelength band may be a wavelength band of approximately 480 nm to 560 nm, and the blue wavelength band may be a wavelength band of approximately 370 nm to 460 nm, but the embodiments of the present specification are not limited thereto. In some embodiments, some of the pixels PX may also emit white light.

Each of the pixels PX may include at least one of an organic light emitting element including an organic material, an inorganic light emitting element including an inorganic semiconductor, a quantum dot light emitting element including a quantum dot light emitting layer, and a micro light emitting diode (LED), as a light emitting element emitting light. Hereinafter, it is mainly described that each of the pixels PX includes the organic light emitting element, but the present disclosure is not limited thereto.

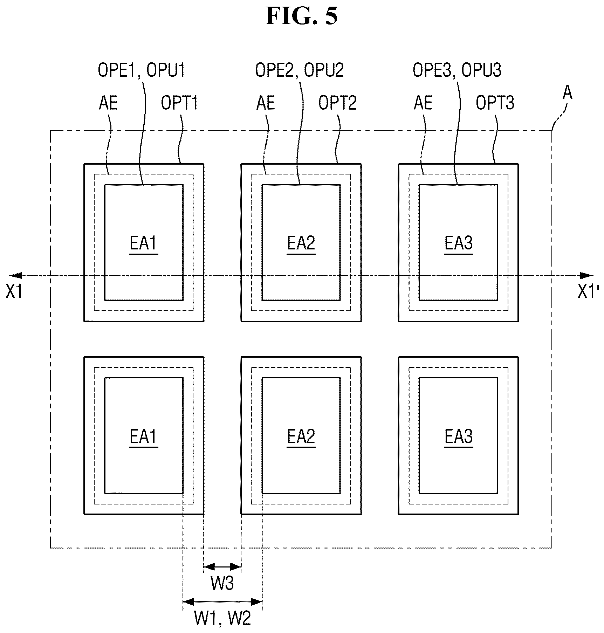

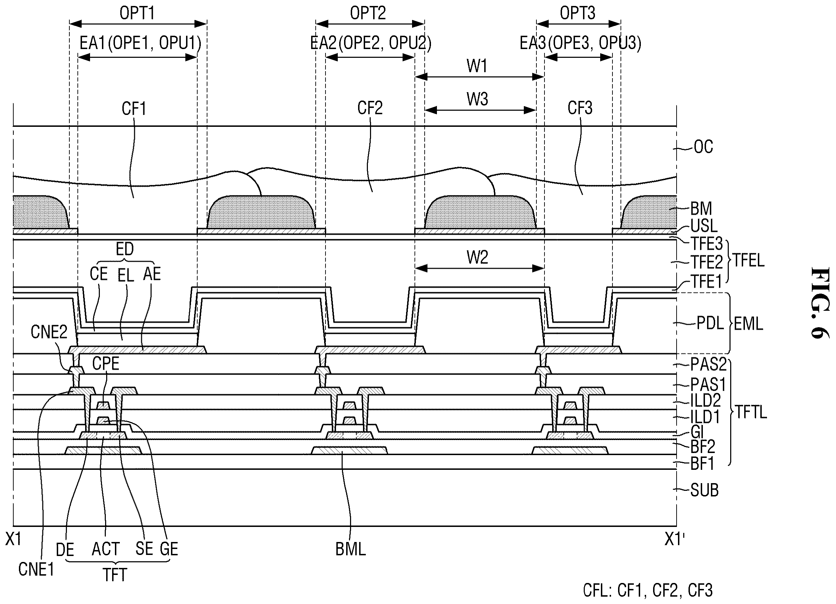

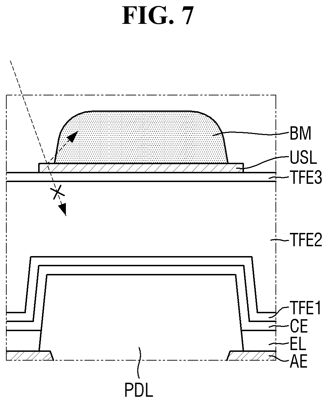

FIG. 5 is an enlarged plan view of area A of FIG. 4. FIG. 6 is a cross-sectional view taken along line X1-X1' of FIG. 5. FIG. 7 is a schematic view illustrating an incident path of external light.

Referring to FIGS. 5 to 7 together with FIG. 2, the display panel 100 of the display device 10 may include the display layer DU and the color filter layer CFL. The display layer DU may include a substrate SUB, a thin film transistor layer TFTL, a light emitting element layer EML, and an encapsulation layer TFEL. The display panel 100 may include a metal oxide layer USL on the encapsulation layer TFEL and a light blocking layer BM disposed on the metal oxide layer USL. Color filters CF1, CF2, and CF3 of the color filter layer CFL may be disposed on the light blocking layer BM.

The substrate SUB may be a base substrate or a base member. The substrate SUB may be a flexible substrate that may be bent, folded, rolled, or the like. For example, the substrate SUB may include a polymer resin such as polyimide (PI), but is not limited thereto. As another example, the substrate SUB may include a glass material or a metal material.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be disposed on the substrate SUB. The first buffer layer BF1 may include an inorganic film capable of preventing permeation of air or moisture. For example, the first buffer layer BF1 may include a plurality of inorganic films alternately stacked.

The lower metal layer BML may be disposed on the first buffer layer BF1. The lower metal layer BML may prevent light incident from below from being incident on a semiconductor layer ACT of the thin film transistor TFT. The lower metal layer BML may be formed as a single layer or multiple layers made of any one of molybdenum (Mo), aluminium (Al), chromium (Cr), gold (Au), titanium (Ti), nickel (Ni), neodymium (Nd), and copper (Cu), or an alloy thereof.

The second buffer layer BF2 may cover the first buffer layer BF1 and the lower metal layer BML. The second buffer layer BF2 may include an inorganic film capable of preventing permeation of air or moisture. For example, the second buffer layer BF2 may include a plurality of inorganic films alternately stacked.

The thin film transistor TFT may be disposed on the second buffer layer BF2, and may constitute a pixel circuit of each of the plurality of pixels. For example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction, and may be insulated from the gate electrode GE by the gate insulating layer GI. In a portion of the semiconductor layer ACT, a material of the semiconductor layer ACT may become a conductor to form the source electrode SE and the drain electrode DE.

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. For example, the gate insulating layer GI may cover the semiconductor layer ACT and the second buffer layer BF2, and may insulate the semiconductor layer ACT and the gate electrode GE from each other. The gate insulating layer GI may include a contact hole through which the first connection electrode CNE1 penetrates.

The first interlayer insulating layer ILD1 may cover the gate electrode GE and the gate insulating layer GI. The first interlayer insulating layer ILD1 may include a contact hole through which the first connection electrode CNE1 penetrates. The contact hole of the first interlayer insulating layer ILD1 may be connected to the contact hole of the gate insulating layer GI and a contact hole of the second interlayer insulating layer ILD2.

The capacitor electrode CPE may be disposed on the first interlayer insulating layer ILD1. The capacitor electrode CPE may overlap the gate electrode GE in the thickness direction. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may include a contact hole through which the first connection electrode CNE1 penetrates. The contact hole of the second interlayer insulating layer ILD2 may be connected to the contact hole of the first interlayer insulating layer ILD1 and the contact hole of the gate insulating layer GI.

The first connection electrode CNE1 may be disposed on the second interlayer insulating layer ILD2. The first connection electrode CNE1 may electrically connect the drain electrode DE of the thin film transistor TFT and the second connection electrode CNE2 to each other. The first connection electrode CNE1 may be inserted into the contact holes formed in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 penetrates.

The second connection electrode CNE2 may be disposed on the first passivation layer PAS1. The second connection electrode CNE2 may electrically connect the first connection electrode CNE1 and a pixel electrode AE of a light emitting element ED to each other. The second connection electrode CNE2 may be inserted into the contact hole formed in the first passivation layer PAS1 and be in contact with the first connection electrode CNE1.

The second passivation layer PAS2 may cover the second connection electrode CNE2 and the first passivation layer PAS1. The second passivation layer PAS2 may include a contact hole through which the pixel electrode AE of the light emitting element ED penetrates.

The light emitting element layer EML may be disposed on the thin film transistor layer TFTL. The light emitting element layer EML may include light emitting elements ED and a pixel defining layer PDL. The light emitting element ED may include a pixel electrode AE, an organic layer EL, and a common electrode CE.

The pixel electrode AE may be disposed on the second passivation layer PAS2. The pixel electrode AE may be disposed to overlap any one of openings OPE1, OPE2, and OPE3 of the pixel defining layer PDL. The pixel electrode AE may be electrically connected to the drain electrode DE of the thin film transistor TFT through the first and second connection electrodes CNE1 and CNE2.

The organic layer EL may be disposed on the pixel electrode AE. For example, the organic layer EL may be an organic light emitting layer made of an organic material, but is not limited thereto. In the case in which the organic layer EL corresponds to the organic light emitting layer, when the thin film transistor TFT applies a predetermined voltage to the pixel electrode AE of the light emitting element ED and the common electrode CE of the light emitting element ED receives a common voltage or a cathode voltage, each of the holes and electrons may move to the organic layer EL through the hole transporting layer and the electron transporting layer, and the holes and electrons may combine with each other in the organic layer EL to emit light.

The common electrode CE may be disposed on the organic layer EL. For example, the common electrode CE may be implemented in the form of an electrode common to all pixels without being divided for each of the plurality of pixels. The common electrode CE may be disposed on the organic layer EL in first to third light emitting areas EA1, EA2, and EA3, and may be disposed on the pixel defining layer PDL in an area excluding the first to third light emitting areas EA1, EA2, and EA3.

The common electrode CE may receive a common voltage or a low potential voltage. In the case in which the pixel electrode AE receives a voltage corresponding to the data voltage and the common electrode CE receives the low potential voltage, as a potential difference is formed between the pixel electrode AE and the common electrode CE, the organic layer EL may emit light.

The pixel defining layer PDL may include a plurality of openings OPE1, OPE2, and OPE3, and may be disposed on the second passivation layer PAS2 and a portion of the pixel electrode AE. The pixel defining layer PDL may include a first opening OPE1, a second opening OPE2, and a third opening OPE3, and each of the openings OPE1, OPE2, and OPE3 may expose a portion of the pixel electrode AE.

Each of the openings OPE1, OPE2, and OPE3 of the pixel defining layer PDL may define the first to third light emitting areas EA1, EA2, and EA3. For example, the first light emitting area EA1 may be defined by the first opening OPE1 of the pixel defining layer PDL, the second light emitting area EA2 may be defined by the second opening OPE2 of the pixel defining layer PDL, and the third light emitting area EA3 may be defined by the third opening OPE3 of the pixel defining layer PDL.

In an embodiment, the areas or sizes of the first to third light emitting areas EA1, EA2, and EA3 may be the same. In another embodiment, the areas or sizes of the first to third light emitting areas EA1, EA2, and EA3 may be different from each other. For example, the area of the first light emitting area EA1 may be greater than the area of each of the second light emitting area EA2 and the third light emitting area EA3, and the area of the second light emitting area EA2 may be greater than the area of the third light emitting area EA3. The areas of the light emitting areas EA1, EA2, and EA3 may vary according to sizes of the openings OPE1, OPE2, and OPE3 formed in the pixel defining layer PDL. Intensities of light emitted from the light emitting areas EA1, EA2, and EA3 may vary depending on the areas of the light emitting areas EA1, EA2, and EA3, and a color of a screen displayed on the display device 10 may be controlled by adjusting the areas of the light emitting areas EA1, EA2, and EA3.

The pixel defining layer PDL may separate and insulate the pixel electrodes AE of the plurality of light emitting elements ED from each other. The pixel defining layer PDL may include a light absorbing material to prevent light reflection. For example, the pixel defining layer PDL may include a polyimide (PI)-based binder and a pigment in which red, green, and blue colors are mixed. Alternatively, the pixel defining layer PDL may include a cardo-based binder resin and a mixture of lactam black pigment and blue pigment. Alternatively, the pixel defining layer PDL may include carbon black.

The encapsulation layer TFEL may be disposed on the common electrode CE to cover the plurality of light emitting elements ED. The encapsulation layer TFEL may include at least one inorganic film to prevent oxygen or moisture from permeating into the light emitting element layer EML. The encapsulation layer TFEL may include at least one organic film to protect the light emitting element layer EML from foreign substances such as dust.

In an embodiment, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFEL2 disposed therebetween may be an organic encapsulation layer.

Each of the first encapsulation layer TFE1 and the third encapsulation layer TFE3 may include one or more inorganic insulating materials. The inorganic insulating material may include aluminium oxide, titanium oxide, tantalum oxide, hafnium oxide, zinc oxide, silicon oxide, silicon nitride, and/or silicon oxynitride.

The second encapsulation layer TFE2 may include a polymer-based material. Examples of the polymer-based material may include an acrylic resin, an epoxy-based resin, polyimide, polyethylene, and the like. For example, the organic encapsulation layer 320 may include an acrylic resin, for example, polymethyl methacrylate or polyacrylic acid. The second encapsulation layer TFE2 may be formed by curing a monomer or applying a polymer.

The light blocking layer BM may be disposed on the encapsulation layer TFEL. The light blocking layer BM may include a plurality of holes OPT1, OPT2, and OPT3 disposed to overlap the light emitting areas EA1, EA2, and EA3. For example, the first hole OPT1 may be disposed to overlap the first light emitting area EA1 or the first opening OPE1. The second hole OPT2 may be disposed to overlap the second light emitting area EA2 or the second opening OPE2, and the third hole OPT3 may be disposed to overlap the third light emitting area EA3 or the third opening OPE3. Areas or sizes of the respective holes OPT1, OPT2, and OPT3 may be greater than the areas or sizes of the openings OPE1, OPE2, and OPE3 of the pixel defining layer PDL. As the holes OPT1, OPT2, and OPT3 of the light blocking layer BM are formed to be greater than the openings OPE1, OPE2, and OPE3 of the pixel defining layer PDL, light emitted from the light emitting areas EA1, EA2, and EA3 may be visually recognized by a user not only from a front side of the display device 10 but also from a side surface thereof.

The light blocking layer BM may include a light absorbing material. For example, the light blocking layer BM may include an inorganic black pigment or an organic black pigment. The inorganic black pigment may be carbon black, and the organic black pigment may include at least one of lactam black, perylene black, and aniline black, but is not limited thereto. The light blocking layer BM may prevent color mixing caused by permeation of visible light between the first to third light emitting areas EA1, EA2, and EA3, thereby improving a color reproduction rate of the display device 10.

Color filters CF1, CF2, and CF3 of the color filter layer CFL may be disposed on the light blocking layer BM. The different color filters CF1, CF2, and CF3 may be disposed to correspond to the different light emitting areas EA1, EA2, and EA3 or the openings OPE1, OPE2, and OPE3, and the holes OPT1, OPT2, and OPT3 of the light blocking layer BM, respectively. The color filters CF1, CF2, and CF3 may include a first color filter CF1, a second color filter CF2, and a third color filter CF3 disposed to correspond to different light emitting areas EA1, EA2, and EA3, respectively. For example, the first color filter CF1 may be disposed to correspond to the first light emitting area EA1, the second color filter CF2 may be disposed to correspond to the second light emitting area EA2, and the third color filter CF3 may be disposed to correspond to the third light emitting area EA3. The first color filter CF1 may be disposed in the first hole OPT1 of the light blocking layer BM, the second color filter CF2 may be disposed in the second hole OPT2 of the light blocking layer BM, and the third color filter CF3 may be disposed in the third hole OPT3 of the light blocking layer BM. Each of the color filters CF1, CF2, and CF3 may be disposed to have a larger area in plan view than the holes OPT1, OPT2, and OPT3 of the light blocking layer BM, and some of the color filters CF1, CF2, and CF3 may be directly disposed on the light blocking layer BM.

The color filters CF1, CF2, and CF3 may include a colorant such as a dye or pigment that absorbs light in a wavelength band other than light in a specific wavelength band, and may be disposed to correspond to the colors of light emitted from the light emitting areas EA1, EA2, and EA3. For example, the first color filter CF1 may be a blue color filter that is disposed to overlap the first light emitting area EA1 and transmits only first light of a blue color. The second color filter CF2 may be a red color filter that is disposed to overlap the second light emitting area EA2 and transmits only second light of a red color, and the third color filter CF3 may be a green color filter that is disposed to overlap the third light emitting area EA3 and transmits only third light of a green color.

A planarization layer OC may be disposed on the color filters CF1, CF2, and CF3 to planarize upper ends of the color filters CF1, CF2, and CF3. The planarization layer OC may be a colorless light-transmitting layer having no color in a visible light band. For example, the planarization layer OC may include a colorless light-transmitting organic material such as an acryl-based resin.

According to an embodiment, the color filters CF1, CF2, and CF3 of the display device 10 may be disposed to overlap other color filters CF1, CF2, and CF3 adjacent thereto on the light blocking layer BM. The color filters CF1, CF2, and CF3 disposed on the light blocking layer BM may be disposed so that two color filters CF1, CF2, and CF3 adjacent to each other completely cover the light blocking layer BM. The two color filters CF1, CF2, and CF3 adjacent to each other may be disposed to partially overlap each other on the light blocking layer BM. The overlapping of the color filters CF1, CF2, and CF3 may reduce reflection of external light by the light blocking layer BM, and an overlapping arrangement of the color filters CF1, CF2, and CF3 may be designed to further reduce the external light reflection.

In the display device 10, the first color filter CF1 and the second color filter CF2 adjacent to each other may be disposed to overlap each other on the light blocking layer BM, and the second color filter CF2 and the third color filter CF3 may also be disposed to overlap each other on the light blocking layer BM. The first color filter CF1 and the third color filter CF3 adjacent to each other may also be disposed to overlap each other on the light blocking layer BM.

According to an embodiment, the metal oxide layer USL may be disposed between the encapsulation layer TFEL and the light blocking layer BM. The metal oxide layer USL may block (e.g., reflect or absorb) light in an ultraviolet wavelength band incident from the outside. When the pixel defining layer PDL disposed on the light emitting element layer EML is exposed to the light in the ultraviolet wavelength band, out-gassing may occur through a chemical reaction. Since the pixel defining layer PDL is in direct contact with the pixel electrode AE, the organic layer EL, and the common electrode CE, gas generated from the pixel defining layer PDL may directly affect the organic layer EL and the common electrode CE. For example, gas ejected from the pixel defining layer PDL may degrade the organic layer EL and oxidize the common electrode CE. Accordingly, a problem of pixel shrinkage in which the area of each of the light emitting areas EA1, EA2, and EA3 is reduced may occur.

In an embodiment, as the metal oxide layer USL capable of blocking light in the ultraviolet wavelength band is disposed between the encapsulation layer TFEL and the light blocking layer BM, it is possible to reduce the occurrence of pixel shrinkage by preventing out-gassing of the pixel defining layer PDL.

The metal oxide layer USL may be directly disposed on the encapsulation layer TFEL. A lower surface of the metal oxide layer USL is in contact with an upper surface of the encapsulation layer TFEL, and may be in direct contact with an upper surface of the third encapsulation layer TFE3 of the encapsulation layer TFEL. In addition, the metal oxide layer USL may be directly disposed on a lower surface of the light blocking layer BM. An upper surface of the metal oxide layer USL may be in direct contact with the lower surface of the light blocking layer BM. When the metal oxide layer USL is disposed on a lower side of the light blocking layer BM, light incident from the outside may be reflected by the metal oxide layer USL and absorbed into the light blocking layer BM. Accordingly, deterioration in visibility due to reflection of external light may be prevented.

The metal oxide layer USL may block (e.g., reflect or absorb) light in an ultraviolet wavelength band incident from the outside. The metal oxide layer USL may include a metal oxide capable of blocking light in the ultraviolet wavelength band. For example, the metal oxide layer USL may include at least one of titanium oxide, zinc oxide, and tantalum oxide. The metal oxide layer USL may have a thickness of 10 to 10000 nm to effectively block light in the ultraviolet wavelength band. Here, when the thickness of the metal oxide layer USL is 10 nm or more, the metal oxide layer USL has excellent characteristics of blocking light in the ultraviolet wavelength band, and when the thickness of the metal oxide layer USL is 10000 nm or less, the metal oxide layer USL may prevent an increase in blocking rate of light in the visible ray wavelength band.

The metal oxide layer USL may include a plurality of opening holes OPU1, OPU2, and OPU3 disposed to overlap the light emitting areas EA1, EA2, and EA3. For example, a first opening hole OPU1 may be disposed to overlap the first light emitting area EA1 or the first opening OPE1. The second opening hole OPU2 may be disposed to overlap the second light emitting area EA2 or the second opening OPE2, and the third opening hole OPU3 may be disposed to overlap the third light emitting area EA3 or the third opening OPE3.

Areas or sizes of the plurality of opening holes OPU1, OPU2, and OPU3 of the metal oxide layer USL may be the same as the areas or sizes of the light emitting areas EA1, EA2, and EA3 or the plurality of openings OPE1, OPE2, and OPE3. For example, the area or size of the first opening hole OPU1 may be the same as the area or size of the first light emitting area EA1 or the first opening OPE1, the area or size of the second opening hole OPU2 may be the same as the area or size of the second light emitting area EA2 or the second opening OPE2, and the area or size of the third opening hole OPU3 may be the same as the area or size of the third light emitting area EA3 or the third opening OPE3.

A side of the metal oxide layer USL may be aligned and matched with a side of the pixel defining layer PDL. For example, a side of the metal oxide layer USL in contact with the first opening hole OPU1 may be aligned and matched with a side of the pixel defining layer PDL in contact with the first opening OPE1. In addition, a side of the metal oxide layer USL in contact with the second opening hole OPU2 may be aligned and matched with a side of the pixel defining layer PDL in contact with the second opening OPE2, and a side of the metal oxide layer USL in contact with the third opening hole OPU3 may be aligned and matched with a side of the pixel defining layer PDL in contact with the third opening OPE3.

A width W1 of the metal oxide layer USL may be the same as a width W2 of the pixel defining layer PDL. The width W1 of the metal oxide layer USL may refer to a distance between the first opening hole OPU1 and the second opening hole OPU2, or between the second opening hole OPU2 and the third opening hole OPU3, or between the third opening hole OPU3 and the first opening hole OPU1. In addition, the width W2 of the pixel defining layer PDL may refer to a distance between the first opening OPE1 and the second opening OPE2, between the second opening OPE2 and the third opening OPE3, or between the third opening OPE3 and the first opening OPE1. For example, the width W1 of the metal oxide layer USL between the first opening hole OPU1 and the second opening hole OPU2 may be the same as the width W2 of the pixel defining layer PDL between the first opening OPE1 and the second opening OPE2. In addition, the width W1 of the metal oxide layer USL between the second opening hole OPU2 and the third opening hole OPU3 may be the same as the width W2 of the pixel defining layer PDL between the second opening OPE2 and the third opening OPE3, and the width W1 of the metal oxide layer USL between the third opening hole OPU3 and the first opening hole OPU1 may be the same as the width W2 of the pixel defining layer PDL between the third opening OPE3 and the first opening OPE1.

Areas or sizes of the plurality of opening holes OPU1, OPU2, and OPU3 of the metal oxide layer USL may be smaller than the areas or sizes of the plurality of holes OPT1, OPT2, and OPT3 of the light blocking layer BM. For example, the area or size of the first opening hole OPU1 may be smaller than the area or size of the first hole OPT1, the area or size of the second opening hole OPU2 may be smaller than the area or size of the second hole OPT2, and the area or size of the third opening hole OPU3 may be smaller than the area or size of the third hole OPT3.

The side of the metal oxide layer USL may more protrude outward than a side of the light blocking layer BM. For example, a side of the metal oxide layer USL in contact with the first opening hole OPU1 may protrude outward more than a side of the light blocking layer BM in contact with the first opening OPE1. In addition, a side of the metal oxide layer USL in contact with the second opening hole OPU2 may protrude outward more than a side of the light blocking layer BM in contact with the second opening OPE2, and a side of the metal oxide layer USL in contact with the third opening hole OPU3 may protrude outward more than a side of the light blocking layer BM in contact with the third opening OPE3.

The width W1 of the metal oxide layer USL may be greater than a width W3 of the light blocking layer BM. The width W3 of the light blocking layer BM may refer to a distance between the first hole OPT1 and the second hole OPT2, or between the second hole OPT2 and the third hole OPT3, or between the third hole OPT3 and the first hole OPT1. For example, the width W1 of the metal oxide layer USL between the first opening hole OPU1 and the second opening hole OPU2 may be greater than the width W3 of the light blocking layer BM between the first hole OPT1 and the second hole OPT2. In addition, the width W1 of the metal oxide layer USL between the second opening hole OPU2 and the third opening hole OPU3 may be greater than the width W3 of the light blocking layer BM between the second hole OPT2 and the third hole OPT3, and the width W1 of the metal oxide layer USL between the third opening hole OPU3 and the first opening hole OPU1 may be greater than the width W3 of the light blocking layer BM between the third hole OPT3 and the first hole OPT1.

As described above, in the display device 10 according to an embodiment, by disposing the metal oxide layer USL absorbing light in the ultraviolet wavelength band between the encapsulation layer TFEL and the light blocking layer BM, it is possible to block light in the ultraviolet wavelength band incident from the outside from reaching the pixel defining layer PDL. Accordingly, deterioration of the organic layer EL and oxidation of the common electrode CE due to out-gassing of the pixel defining layer PDL may be prevented, thereby preventing a pixel shrinkage phenomenon.

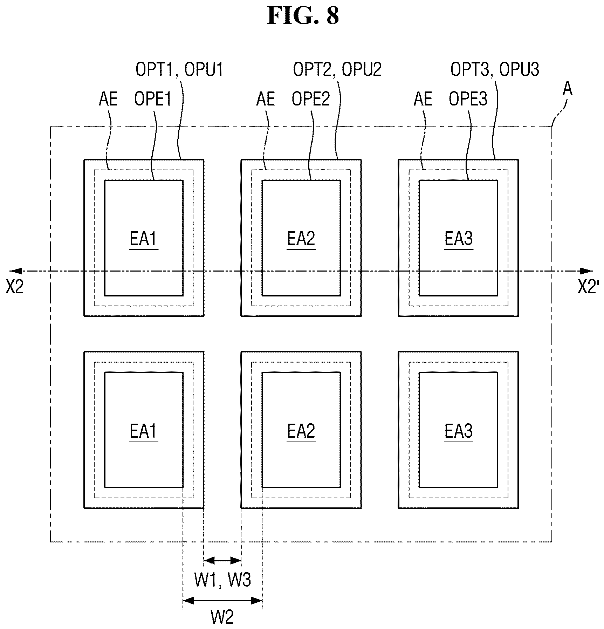

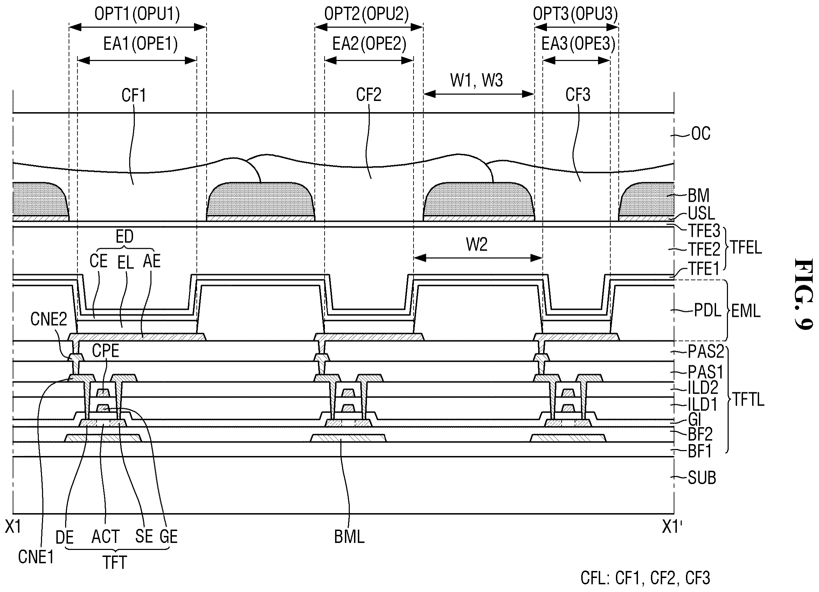

FIG. 8 is a plan view illustrating pixels according to another embodiment. FIG. 9 is a cross-sectional view taken along line X2-X2' of FIG. 8.

Referring to FIGS. 8 and 9, the present embodiment is different from the embodiments of FIGS. 5 to 7 described above in that the width W1 of the metal oxide layer USL is the same as the width W3 of the light blocking layer BM and smaller than the width W2 of the pixel defining layer PDL. Hereinafter, the descriptions overlapping the above-described embodiment will be omitted and differences from the above-described embodiment will be described.

The areas or sizes of the plurality of opening holes OPU1, OPU2, and OPU3 of the metal oxide layer USL may be greater than the areas or sizes of the light emitting areas EA1, EA2, and EA3 or the plurality of openings OPE1, OPE2, and OPE3. For example, the area or size of the first opening hole OPU1 may be greater than the area or size of the first light emitting area EA1 or the first opening OPE1, the area or size of the second opening hole OPU2 may be greater than the area or size of the second light emitting area EA2 or the second opening OPE2, and the area or size of the third opening hole OPU3 may be greater than the area or size of the third light emitting area EA3 or the third opening OPE3.

A side of the metal oxide layer USL may be disposed inward more than a side of the pixel defining layer PDL. For example, a side of the metal oxide layer USL in contact with the first opening hole OPU1 may be disposed inward more than a side of the pixel defining layer PDL in contact with the first opening OPE1. In addition, a side of the metal oxide layer USL in contact with the second opening hole OPU2 may be disposed inward more than a side of the pixel defining layer PDL in contact with the second opening OPE2, and a side of the metal oxide layer USL in contact with the third opening hole OPU3 may be disposed inward more than a side of the pixel defining layer PDL in contact with the third opening OPE3.

A width W1 of the metal oxide layer USL may be smaller than a width W2 of the pixel defining layer PDL. For example, the width W1 of the metal oxide layer USL between the first opening hole OPU1 and the second opening hole OPU2 may be smaller than the width W2 of the pixel defining layer PDL between the first opening OPE1 and the second opening OPE2. In addition, the width W1 of the metal oxide layer USL between the second opening hole OPU2 and the third opening hole OPU3 may be smaller than the width W2 of the pixel defining layer PDL between the second opening OPE2 and the third opening OPE3, and the width W1 of the metal oxide layer USL between the third opening hole OPU3 and the first opening hole OPU1 may be smaller than the width W2 of the pixel defining layer PDL between the third opening OPE3 and the first opening OPE1.

Areas or sizes of the plurality of opening holes OPU1, OPU2, and OPU3 of the metal oxide layer USL may be the same as the areas or sizes of the plurality of holes OPT1, OPT2, and OPT3 of the light blocking layer BM. For example, the area or size of the first opening hole OPU1 may be the same as the area or size of the first hole OPT1, the area or size of the second opening hole OPU2 may be the same as the area or size of the second hole OPT2, and the area or size of the third opening hole OPU3 may be the same as the area or size of the third hole OPT3.

The side of the metal oxide layer USL may be aligned and matched with a side of the light blocking layer BM. For example, a side of the metal oxide layer USL in contact with the first opening hole OPU1 may be aligned and matched with a side of the light blocking layer BM in contact with the first hole OPT1. In addition, a side of the metal oxide layer USL in contact with the second opening hole OPU2 may be aligned and matched with a side of the light blocking layer BM in contact with the second hole OPT2, and a side of the metal oxide layer USL in contact with the third opening hole OPU3 may be aligned and matched with a side of the light blocking layer BM in contact with the third hole OPT3.

The width W1 of the metal oxide layer USL may be the same as a width W3 of the light blocking layer BM. For example, the width W1 of the metal oxide layer USL between the first opening hole OPU1 and the second opening hole OPU2 may be the same as the width W3 of the light blocking layer BM between the first hole OPT1 and the second hole OPT2. In addition, the width W1 of the metal oxide layer USL between the second opening hole OPU2 and the third opening hole OPU3 may be the same as the width W3 of the light blocking layer BM between the second hole OPT2 and the third hole OPT3, and the width W1 of the metal oxide layer USL between the third opening hole OPU3 and the first opening hole OPU1 may be the same as the width W3 of the light blocking layer BM between the third hole OPT3 and the first hole OPT1.

As described above, in the display device 10 according to an embodiment, by disposing the metal oxide layer USL absorbing light in the ultraviolet wavelength band between the encapsulation layer TFEL and the light blocking layer BM, it is possible to reduce that light in the ultraviolet wavelength band incident from the outside reaches the pixel defining layer PDL. Accordingly, deterioration of the organic layer EL and oxidation of the common electrode CE due to out-gassing of the pixel defining layer PDL may be reduced, thereby reducing a pixel shrinkage phenomenon.

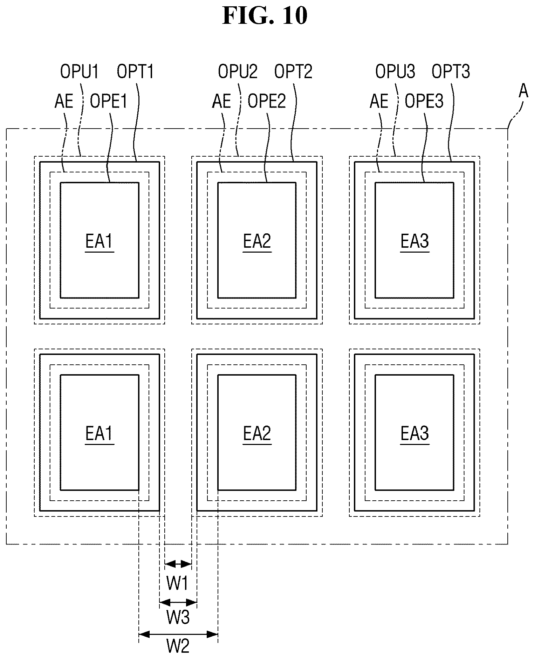

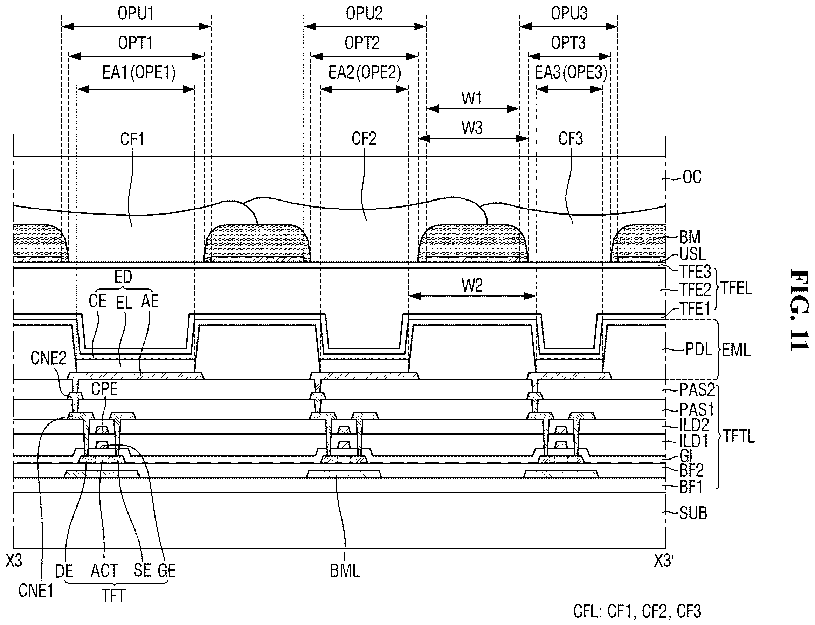

FIG. 10 is a plan view illustrating pixels according to still another embodiment. FIG. 11 is a cross-sectional view taken along line X3-X3' of FIG. 10.

Referring to FIGS. 10 and 11, the present embodiment is different from the embodiments of FIGS. 5 to 9 described above in that the width W1 of the metal oxide layer USL is smaller than the width W3 of the light blocking layer BM and the width W2 of the pixel defining layer PDL. Hereinafter, the descriptions overlapping the above-described embodiment will be omitted and differences from the above-described embodiment will be described.

The metal oxide layer USL may be disposed between the encapsulation layer TFEL and the light blocking layer BM. The metal oxide layer USL may be disposed between the third encapsulation layer TFE3 of the encapsulation layer TFEL and the light blocking layer BM. The light blocking layer BM may cover the metal oxide layer USL. For example, the light blocking layer BM may be in direct contact with the upper surface and sides of the metal oxide layer USL.

The areas or sizes of the plurality of opening holes OPU1, OPU2, and OPU3 of the metal oxide layer USL may be greater than the areas or sizes of the light emitting areas EA1, EA2, and EA3 or the plurality of openings OPE1, OPE2, and OPE3. For example, the area or size of the first opening hole OPU1 may be greater than the area or size of the first light emitting area EA1 or the first opening OPE1, the area or size of the second opening hole OPU2 may be greater than the area or size of the second light emitting area EA2 or the second opening OPE2, and the area or size of the third opening hole OPU3 may be greater than the area or size of the third light emitting area EA3 or the third opening OPE3.

A side of the metal oxide layer USL may be disposed inward more than a side of the pixel defining layer PDL. For example, a side of the metal oxide layer USL in contact with the first opening hole OPU1 may be disposed inward more than a side of the pixel defining layer PDL in contact with the first opening OPE1. In addition, a side of the metal oxide layer USL in contact with the second opening hole OPU2 may be disposed inward more than a side of the pixel defining layer PDL in contact with the second opening OPE2, and a side of the metal oxide layer USL in contact with the third opening hole OPU3 may be disposed inward more than a side of the pixel defining layer PDL in contact with the third opening OPE3.

The width W1 of the metal oxide layer USL may be smaller than the width W2 of the pixel defining layer PDL. For example, the width W1 of the metal oxide layer USL between the first opening hole OPU1 and the second opening hole OPU2 may be smaller than the width W2 of the pixel defining layer PDL between the first opening OPE1 and the second opening OPE2. In addition, the width W1 of the metal oxide layer USL between the second opening hole OPU2 and the third opening hole OPU3 may be smaller than the width W2 of the pixel defining layer PDL between the second opening OPE2 and the third opening OPE3, and the width W1 of the metal oxide layer USL between the third opening hole OPU3 and the first opening hole OPU1 may be smaller than the width W2 of the pixel defining layer PDL between the third opening OPE3 and the first opening OPE1.

The areas or sizes of the plurality of opening holes OPU1, OPU2, and OPU3 of the metal oxide layer USL may be greater than the areas or sizes of the plurality of holes OPT1, OPT2, and OPT3 of the light blocking layer BM. For example, the area or size of the first opening hole OPU1 may be greater than the area or size of the first hole OPT1, the area or size of the second opening hole OPU2 may be greater than the area or size of the second hole OPT2, and the area or size of the third opening hole OPU3 may be greater than the area or size of the third hole OPT3.

The side of the metal oxide layer USL may be disposed inward more than the side of the light blocking layer BM. For example, a side of the metal oxide layer USL in contact with the first opening hole OPU1 may be disposed inward more than a side of the light blocking layer BM in contact with the first opening OPT1. In addition, a side of the metal oxide layer USL in contact with the second opening hole OPU2 may be disposed inward more than a side of the light blocking layer BM in contact with the second opening OPT2, and a side of the metal oxide layer USL in contact with the third opening hole OPU3 may be disposed inward more than a side of the light blocking layer BM in contact with the third opening OPT3.

The width W1 of the metal oxide layer USL may be smaller than a width W3 of the light blocking layer BM. For example, the width W1 of the metal oxide layer USL between the first opening hole OPU1 and the second opening hole OPU2 may be smaller than the width W3 of the light blocking layer BM between the first hole OPT1 and the second hole OPT2. In addition, the width W1 of the metal oxide layer USL between the second opening hole OPU2 and the third opening hole OPU3 may be smaller than the width W3 of the light blocking layer BM between the second hole OPT2 and the third hole OPT3, and the width W1 of the metal oxide layer USL between the third opening hole OPU3 and the first opening hole OPU1 may be smaller than the width W3 of the light blocking layer BM between the third hole OPT3 and the first hole OPT1.

As described above, in the display device 10 according to an embodiment, by disposing the metal oxide layer USL absorbing light in the ultraviolet wavelength band between the encapsulation layer TFEL and the light blocking layer BM, it is possible to reduce that light in the ultraviolet wavelength band incident from the outside reaches the pixel defining layer PDL. Accordingly, deterioration of the organic layer EL and oxidation of the common electrode CE due to out-gassing of the pixel defining layer PDL may be reduced, thereby reducing a pixel shrinkage phenomenon.

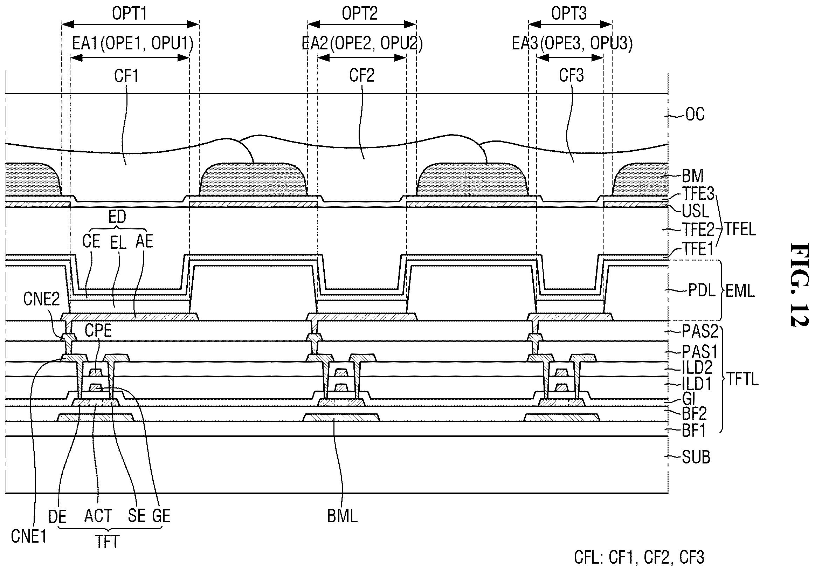

FIG. 12 is a cross-sectional view illustrating a display device according to still another embodiment.

Referring to FIG. 12, the present embodiment is different from the embodiments of FIGS. 5 to 11 described above in that the metal oxide layer USL is disposed between the second encapsulation layer TFE2 and the third encapsulation layer TFE3 of the encapsulation layer TFEL. Hereinafter, the descriptions overlapping the above-described embodiment will be omitted and differences from the above-described embodiment will be described.

The metal oxide layer USL may be disposed within the encapsulation layer TFEL. Specifically, the metal oxide layer USL may be disposed between the second encapsulation layer TFE2 and the third encapsulation layer TFE3 of the encapsulation layer TFEL. For example, the metal oxide layer USL may be directly disposed on the upper surface of the second encapsulation layer TFE2 and covered by the third encapsulation layer TFE3. That is, the third encapsulation layer TFE3 may cover the metal oxide layer USL.

In an embodiment, the metal oxide layer USL may be disposed on a lower side of the third encapsulation layer TFE3 and disposed to be adjacent to the pixel defining layer PDL. That is, as the metal oxide layer USL is disposed to be adjacent to the pixel defining layer PDL, the amount of light incident on the pixel defining layer PDL may be reduced by reducing an incident angle of light in the ultraviolet wavelength band incident from the outside.

The metal oxide layer USL may overlap the pixel defining layer PDL and may overlap the light blocking layer BM. The metal oxide layer USL may include a plurality of opening holes OPU1, OPU2, and OPU3. As described with reference to FIGS. 5 and 6, the areas or sizes of the plurality of opening holes OPU1, OPU2, and OPU3 of the metal oxide layer USL may be the same as the areas or sizes of the light emitting areas EA1, EA2, and EA3 or the plurality of openings OPE1, OPE2, and OPE3. In addition, the side of the metal oxide layer USL may be aligned and matched with the side of the pixel defining layer PDL. The areas or sizes of the plurality of opening holes OPU1, OPU2, and OPU3 of the metal oxide layer USL may be smaller than the areas or sizes of the plurality of holes OPT1, OPT2, and OPT3 of the light blocking layer BM.

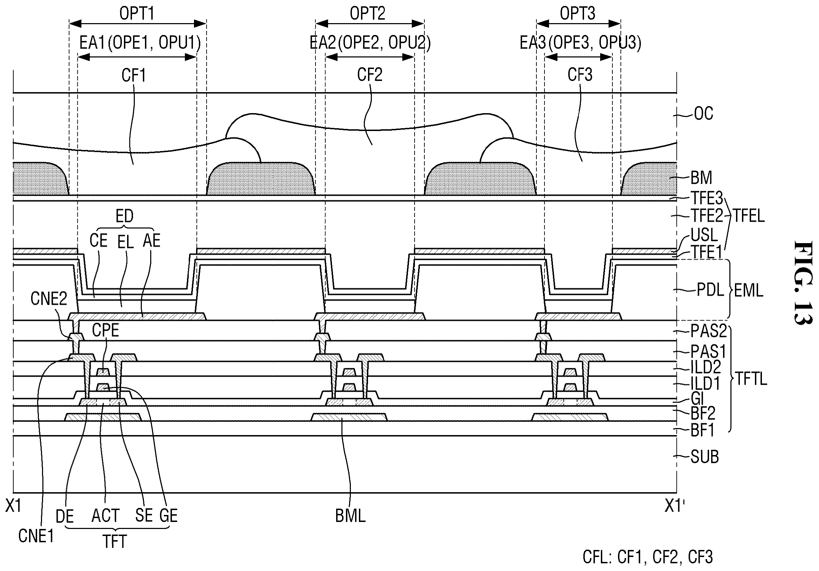

FIG. 13 is a cross-sectional view illustrating a display device according to still another embodiment.

Referring to FIG. 13, the present embodiment is different from the embodiments of FIGS. 5 to 12 described above in that the metal oxide layer USL is disposed between the first encapsulation layer TFE1 and the second encapsulation layer TFE2 of the encapsulation layer TFEL. Hereinafter, the descriptions overlapping the above-described embodiment will be omitted and differences from the above-described embodiment will be described.

The metal oxide layer USL may be disposed within the encapsulation layer TFEL. Specifically, the metal oxide layer USL may be disposed between the first encapsulation layer TFE1 and the second encapsulation layer TFE2 of the encapsulation layer TFEL. For example, the metal oxide layer USL may be directly disposed on the upper surface of the first encapsulation layer TFE1 and covered by the second encapsulation layer TFE2. That is, the second encapsulation layer TFE2 may cover the metal oxide layer USL.

In an embodiment, the metal oxide layer USL may be disposed on a lower side of the second encapsulation layer TFE2 and disposed to be adjacent to the pixel defining layer PDL. That is, as the metal oxide layer USL is disposed to be adjacent to the pixel defining layer PDL, the amount of light incident on the pixel defining layer PDL may be reduced by reducing an incident angle of light in the ultraviolet wavelength band incident from the outside.

The metal oxide layer USL may overlap the pixel defining layer PDL and may overlap the light blocking layer BM. The metal oxide layer USL may include a plurality of opening holes OPU1, OPU2, and OPU3. As described with reference to FIGS. 5 and 6, the areas or sizes of the plurality of opening holes OPU1, OPU2, and OPU3 of the metal oxide layer USL may be the same as the areas or sizes of the light emitting areas EA1, EA2, and EA3 or the plurality of openings OPE1, OPE2, and OPE3. In addition, the side of the metal oxide layer USL may be aligned and matched with the side of the pixel defining layer PDL. The areas or sizes of the plurality of opening holes OPU1, OPU2, and OPU3 of the metal oxide layer USL may be smaller than the areas or sizes of the plurality of holes OPT1, OPT2, and OPT3 of the light blocking layer BM.

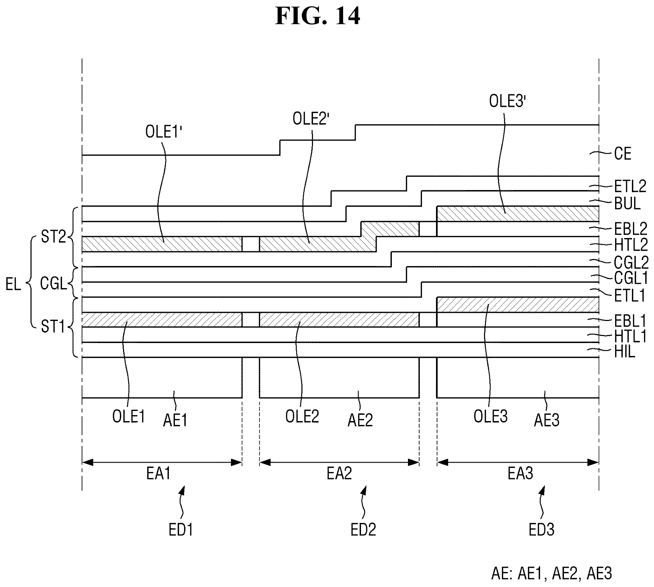

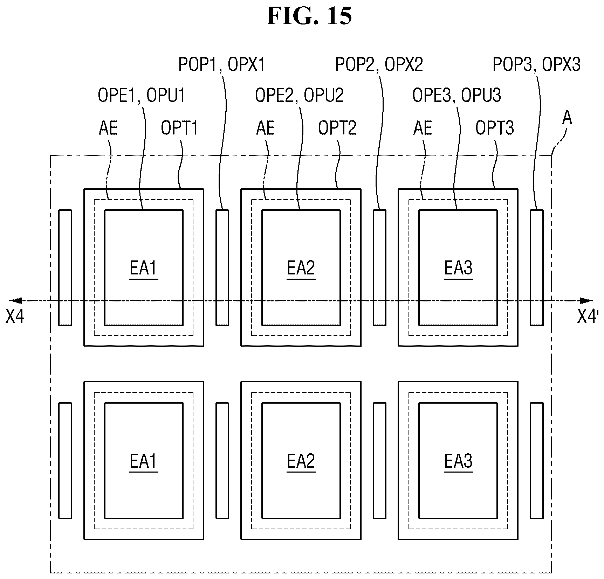

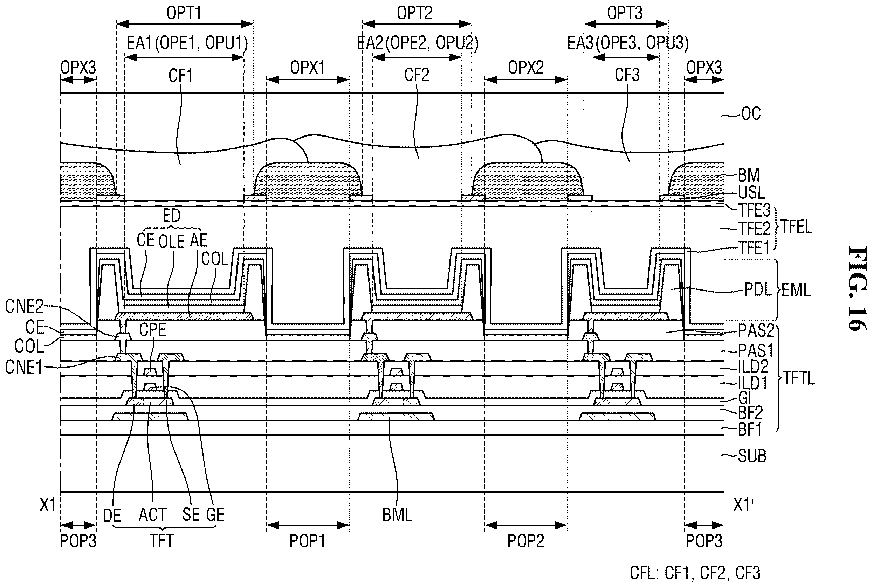

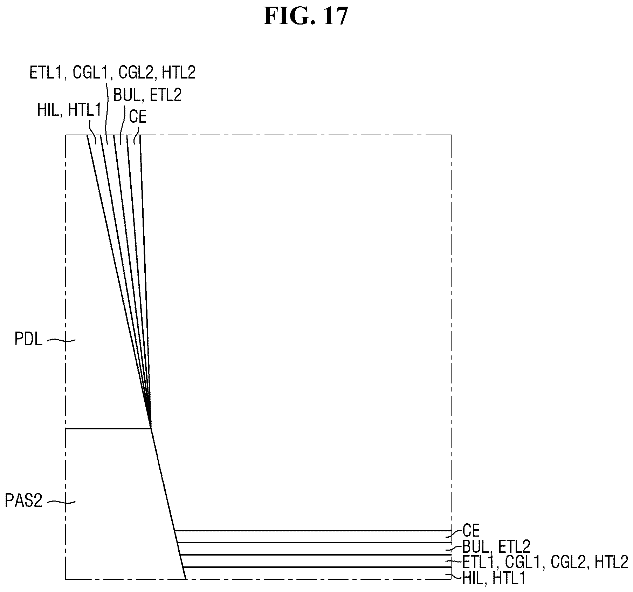

FIG. 14 is a cross-sectional view illustrating each light emitting area of the display device according to an embodiment. FIG. 15 is a plan view illustrating each light emitting area of the display device according to an embodiment. FIG. 16 is a cross-sectional view taken along line X4-X4' of FIG. 15. FIG. 17 is a cross-sectional view illustrating a portion of a pixel opening of the display device according to an embodiment.

In FIG. 16, lower light emitting layers OLE1, OLE2, and OLE3 and upper light emitting layers OLE1', OLE2', and OLE3' are denoted as one layer by reference numeral "OLE", and common layers continuously formed in each of the light emitting areas EA1, EA2, and EA3, for example, a hole injection layer HIL, a first hole transporting layer HTL1, a first electron transporting layer ETL1, a charge generation layer CGL, a second hole transporting layer HTL2, a buffer layer BUL, and a second electron transporting layer ETL2 are denoted as one layer by reference numeral "COL". In addition, in FIG. 17, the hole injection layer HIL and the first hole transporting layer HTL1 are illustrated as one layer, the first electron transporting layer ETL1, the charge generation layer CGL, and the second hole transporting layer HTL2 are illustrated as one layer, and the buffer layer BUL and the second electron transporting layer ETL2 are illustrated as one layer.

Referring to FIGS. 14 to 17, the present embodiment is different from the embodiments of FIGS. 5 to 13 described above in that pattern openings OPX1, OPX2, and OPX3 of the metal oxide layer USL are disposed on pixel openings POP1, POP2, and POP3 disposed on the pixel defining layer PDL and the second passivation layer PAS2. Hereinafter, descriptions overlapping the above-described embodiments will be omitted and differences from the above-described embodiments will be described.

Referring to FIG. 14, light emitting elements ED1, ED2, and ED3 are disposed in the first light emitting area EA1, the second light emitting area EA2, and the third light emitting area EA3, respectively, and each of the light emitting elements ED1, ED2, and ED3 may include a pixel electrode AE, an organic layer EL, and a common electrode CE.

The organic layer EL may have a structure in which a plurality of light emitting layers are overlapped, for example, a tandem structure. The organic layer EL may include a first stack ST1 including lower light emitting layers OLE1, OLE2, and OLE3, a second stack ST2 positioned on the first stack ST1 and including upper light emitting layers OLE1', OLE2', and OLE3', and a charge generation layer CGL positioned between the first stack ST1 and the second stack ST2. The first stack ST1 and the second stack ST2 may be disposed to overlap each other.

The lower light emitting layers OLE1, OLE2, and OLE3 and the upper light emitting layers OLE1', OLE2', and OLE3' may be disposed to overlap each other.

The first lower light emitting layer OLE1 and the first upper light emitting layer OLE1' may emit light of a first color, for example, blue light. The second lower light emitting layer OLE2 and the second upper light emitting layer OLE2' may emit light of a second color, for example, red light. The third lower light emitting layer OLE3 and the third upper light emitting layer OLE3' may emit light of a third color, for example, green light. That is, emission light finally emitted from the organic layer EL may be blue light in the first light emitting area EA1, be red light in the second light emitting area EA2, and be green light in the third light emitting area EA3.

In some embodiments, each of the first lower light emitting layer OLE1 and the first upper light emitting layer OLE1' emitting blue light may include a host and a dopant. The host is not particularly limited as long as it is a commonly used material, but, for example, Alq3(tris(8-hydroxyquinolino)aluminum), CBP(4,4'-bis(N-carbazolyl)-1,1'-biphenyl), PVK(poly(n-vinylcabazole)), ADN(9,10-di(naphthalene-2-yl)anthracene), TCTA(4,4',4"-Tris(carbazol-9-yl)-triphenylamine), TPBi(1,3,5-tris(N-phenylbenzimidazole-2-yl)benzene), TBADN(3-tert-butyl-9,10-di(naphth-2-yl)anthracene), DSA(distyrylarylene), CDBP(4,4'-bis(9-carbazolyl)-2,2"-dimethylbiphenyl), MADN(2-Methyl-9,10-bis(naphthalen-2-yl)anthracene), or the like may be used.

In addition, the first lower light emitting layer OLE1 and the first upper light emitting layer OLE1' emitting blue light may include a fluorescent material including any one selected from the group consisting of, for example, spiro-DPVBi, spiro-6P, distyryl-benzene (DSB), distyryl-arylene (DSA), polyfluorene (PFO)-based polymers, and poly(p-phenylene vinylene) (PPV)-based polymers. As another example, the first lower light emitting layer OLE1 and the first upper light emitting layer OLE1' emitting blue light may also include a phosphorescent material containing an organometallic complex such as (4,6-F2ppy)2Irpic.

In some embodiments, a second lower light emitting layer OLE2 and a second upper light emitting layer OLE2' emitting red light may include a host material including carbazole biphenyl (CBP) or 1,3-bis (carbazol-9-yl) mCP, may be made of a phosphorescent material including a dopant including any one or more selected from the group consisting of PIQIr(acac)(bis(1-phenylisoquinoline)acetylacetonate iridium), PQIr(acac)(bis(1-phenylquinoline)acetylacetonate iridium), PQIr(tris(1-phenylquinoline)iridium), and PtOEP(octaethylporphyrin platinum), and may be made of a fluorescent material including PBD:Eu(DBM)₃(Phen) or Perylene unlike this, but are not limited thereto.

In some embodiments, a third lower light emitting layer OLE3 and a third upper light emitting layer OLE3' emitting green light may include a host material including CBP or mCP, may be made of a phosphorescent material including a dopant material including Ir(ppy)3(fac tris(2-phenylpyridine)iridium), and may be made of a fluorescent material including Alq3(tris(8-hydroxyquinolino)aluminum) unlike this, but are not limited thereto.

The charge generation layer CGL may be disposed between the first stack ST1 and the second stack ST2. The charge generation layer CGL may serve to inject charges into each light emitting layer. The charge generation layer CGL may serve to adjust a charge balance between the first stack ST1 and the second stack ST2. The charge generation layer CGL may include an n-type charge generation layer CGL1 and a p-type charge generation layer CGL2. The p-type charge generation layer CGL2 may be disposed on the n-type charge generation layer CGL1, and may be positioned between the n-type charge generation layer CGL1 and the second stack ST2.

The charge generation layer CGL may have a structure in which the n-type charge generation layer CGL1 and the p-type charge generation layer CGL2 are bonded to each other. The n-type charge generation layer CGL1 may be disposed closer to the pixel electrode AE among the pixel electrode AE and the common electrode CE. The p-type charge generation layer CGL2 may be disposed closer to the common electrode CE among the pixel electrode AE and the common electrode CE. The n-type charge generation layer CGL1 supplies electrons to the lower light emitting layers OLE1, OLE2, and OLE3 adjacent to the pixel electrodes AE1, AE2, and AE3, and the p-type charge generation layer CGL2 supplies holes to the upper light emitting layer OLE1', OLE2', and OLE3' included in the second stack ST2. The charge generation layer CGL may be disposed between the first stack ST1 and the second stack ST2 to provide the charges to each of the light emitting layers, thereby increasing emission efficiency and lowering a driving voltage.

The first stack ST1 may be disposed on the first pixel electrode AE1, the second pixel electrode AE2, and the third pixel electrode AE3, and may further include a first hole transporting layer HTL1, a first electron block layer EBL1, and a first electron transporting layer ETL1.

The first hole transporting layer HTL1 may be disposed on the first pixel electrode AE1, the second pixel electrode AE2, and the third pixel electrode AE3, respectively. The first hole transporting layer HTL1 may serve to smoothly transport holes and may include a hole transport material. The hole transport material may include carbazole-based derivatives such as N-phenylcarbazole and polyvinylcarbazole; fluorene-based derivatives, triphenylamine-based derivatives such as TPD(N,N'-bis(3-methylphenyl)-N,N'-diphenyl-[1,1-biphenyl]-4,4'-diamine), TCTA(4,4',4"-tris(N-carbazolyl)triphenylamine), or the like, NPB(N,N'-di(1-naphthyl)-N,N'-diphenylbenzidine), TAPC(4,4'-Cyclohexylidene bis[N,N-bis(4-methylphenyl)benzenamine]), or the like, but is not limited thereto.

The first electron block layer EBL1 may be positioned on the first hole transporting layer HTL1, and may be positioned between the first hole transporting layer HTL1 and the lower light emitting layers OLE1, OLE2, and OLE3. The first electron block layer EBL1 may include a hole transport material and a metal or a metal compound to prevent electrons generated in the lower light emitting layers OLE1, OLE2, and OLE3 from passing over to the first hole transporting layer HTL1. In some embodiments, the first hole transporting layer HTL1 and first electron block layer EBL1 that are described above may also be formed as a single layer in which the respective materials are mixed.

The first electron transporting layer ETL1 may be disposed on the lower light emitting layers OLE1, OLE2, and OLE3 and may be disposed between the charge generation layer CGL and the lower light emitting layers OLE1, OLE2, and OLE3. In some embodiments, the first electron transporting layer ETL1 may include an electron transport material such as Alq3(Tris(8-hydroxyquinolinato)aluminum), TPBi(1,3,5-Tri(1-phenyl-1H-benzo[d]imidazol-2-yl)phenyl), BCP(2,9-Dimethyl-4,7-diphenyl-1,10-phenanthroline), Bphen(4,7-Diphenyl-1,10-phenanthroline), TAZ(3-(4-Biphenylyl)-4-phenyl-5-tert-butylphenyl-1,2,4-triazole), NTAZ(4-(Naphthalen-1-yl)-3,5-diphenyl-4H-1,2,4-triazole), tBu-PBD(2-(4-Biphenylyl)-5-(4-tert-butylphenyl)-1,3,4-oxadiazole), BAlq(Bis(2-methyl-8-quinolinolato-N1,O8)-(1,1'-Biphenyl-4-olato)aluminum), Bebq2(berylliumbis(benzoquinolin-10-olate), ADN(9,10-di(naphthalene-2-yl)anthracene), and mixtures thereof. However, the present disclosure is not limited to the type of the electron transport material.

The second stack ST2 may be disposed on the charge generation layer CGL and may further include a second hole transporting layer HTL2, a second electron block layer EBL2, a buffer layer BUL, and a second electron transporting layer ETL2.

The second hole transporting layer HTL2 may be positioned on the charge generation layer CGL. The second hole transporting layer HTL2 may be made of the same material as the first hole transporting layer HTL1, or may also include one or more materials selected from the materials exemplified as the material included in the first hole transporting layer HTL1. The second hole transporting layer HTL2 may be made as a single layer or a plurality of layers.

The second electron block layer EBL2 may be positioned on the second hole transporting layer HTL2, and may be disposed between the second hole transporting layer HTL2 and the upper light emitting layers OLE1', OLE2', and OLE3'. The second electron block layer EBL2 may be made of the same material and the same structure as the first electron block layer EBL1, or may also include one or more materials selected from the materials exemplified as the material included in the first electron block layer EBL1.

The second electron transporting layer ETL2 may be disposed on the upper light emitting layers OLE1', OLE2', and OLE3' and may be disposed between the upper light emitting layers OLE1', OLE2', and OLE3' and the common electrode CE. The second electron transporting layer ETL2 may be made of the same material and the same structure as the first electron transporting layer ETL1, or may also include one or more materials selected from the materials exemplified as the material included in the first electron transporting layer ETL1. The second electron transporting layer ETL2 may be made as a single layer or a plurality of layers.

The buffer layer BUL may be disposed between the upper light emitting layers OLE1', OLE2', and OLE3' and the second electron transporting layer ETL2. The buffer layer BUL may prevent holes from passing over to the common electrode CE from the upper light emitting layers OLE1', OLE2', and OLE3'. The buffer layer BUL may include, for example, a hole transporting layer material as materials having hole properties, but is not limited thereto.

Although not illustrated in the drawing, a hole injection layer may be further disposed between the first stack ST1 and the first pixel electrode AE1, the second pixel electrode AE2, and the third pixel electrode AE3 or between the second stack ST2 and the charge generation layer CGL1. The hole injection layer may serve to more smoothly inject holes into the lower light emitting layers OLE1, OLE2, and OLE3 and the upper light emitting layers OLE1', OLE2', and OLE3'. In some embodiments, the hole injection layer may be made of one or more selected from the group consisting of copper phthalocyanine (CuPc), poly(3,4)-ethylenedioxythiophene (PEDOT), polyaniline (PANI), and N,N-dinaphthyl-N,N'-diphenyl benzidine (NPD), but is not limited thereto.

In addition, although not illustrated in the drawing, an electron injection layer may be further positioned between the second electron transporting layer ETL2 and the common electrode CE or between the charge generation layer CGL and the first stack ST1. The electron injection layer serves to smoothly inject electrons, and may include, but is not limited to, Alq3(tris(8-hydroxyquinolino)aluminum), PBD, TAZ, spiro-PBD, BAlq, or SAlq. In addition, the electron injection layer may be a metal halide compound, and may be, for example, one or more selected from the group consisting of MgF₂, LiF, NaF, KF, RbF, CsF, FrF, Lil, Nal, KI, Rbl, Csl, Frl, and CaF₂, but is not limited thereto. In addition, the electron injection layer may also include a lanthanide-based material such as Yb, Sm, or Eu. Alternatively, the electron injection layer may simultaneously include a metal halide material and a lanthanide-based material such as Rbl:Yb, KI:Yb, and the like. When the electron injection layer includes both the metal halide material and the lanthanide-based material, the electron injection layer may be formed by codeposition of the metal halide material and the lanthanide-based material.

In FIG. 14 described above, the charge generation layer CGL may be a common layer extending to and continuously disposed in the plurality of light emitting areas EA1, EA2, and EA3. For example, in FIG. 14, the charge generation layer CGL may be a common layer continuously disposed in the first light emitting area EA1, the second light emitting area EA2, and the third light emitting area EA3. The charge generation layer CGL may serve to generate and transfer electrons and holes contributing to substantial light emission. When the charge generation layer CGL is the common layer, a leakage current may occur in which charges (electrons and holes) generated in the light emitting areas adjacent to each other are transferred to the light emitting areas adjacent to each other. In this case, since light is emitted by leakage current in a light emitting area where light is not supposed to be emitted, color mixture may occur or an unwanted gray scale may be expressed.

According to the present embodiment, the leakage current may be reduced by forming the pixel openings POP1, POP2, and POP3 that may increase a path of charge movement by partially shorting the charge generation layer CGL between the light emitting areas EA1, EA2, and EA3, and the unnecessary metal oxide layer USL may be omitted by forming the pattern openings OPX1, OPX2, and OPX3 in the metal oxide layer USL.

As illustrated in FIGS. 15 to 17, the second passivation layer PAS2 and the pixel defining layer PDL may include a plurality of pixel openings POP1, POP2, and POP3. The plurality of pixel openings POP1, POP2, and POP3 may be disposed between the first to third light emitting areas EA1, EA2, and EA3 so as not to overlap the first to third light emitting areas EA1, EA2, and EA3. The plurality of pixel openings POP1, POP2, and POP3 may be disposed to overlap the light blocking layer BM. In the present embodiment, it is illustrated that the plurality of pixel openings POP1, POP2, and POP3 are disposed between the first to third light emitting areas EA1, EA2, and EA3, but the present disclosure is not limited thereto, and some of the plurality of pixel openings POP1, POP2, and POP3 may also be omitted. The plurality of pixel openings POP1, POP2, and POP3 may include a first pixel opening POP1 disposed between the first light emitting area EA1 and the second light emitting area EA2, a second pixel opening POP2 disposed between the second light emitting area EA2 and the third light emitting area EA3, and a third pixel opening POP3 disposed between the third light emitting area EA3 and the first light emitting area EA1.

Common layers of the organic layer EL may be separated from each other in the plurality of pixel openings POP1, POP2, and POP3. The pixel defining layer PDL and the second passivation layer PAS2 are layers made of an organic material and may have a very thick thickness compared to a layer made of an inorganic material. For example, the pixel defining layer PDL and the second passivation layer PAS2 may have a thickness of about several micrometers. Sides of the plurality of pixel openings POP1, POP2, and POP3 formed in the pixel defining layer PDL and the second passivation layer PAS2 are very tapered, so that the common layers having a very thin thickness, such as a hole injection layer HIL, a first hole transporting layer HTL1, a first electron transporting layer ETL1, a charge generation layer CGL, a second hole transporting layer HTL2, a buffer layer BUL, and the second electron transporting layer ETL2 may be separated. Accordingly, as the common layers are separated from each other in the plurality of pixel openings POP1, POP2, and POP3, the leakage current in which charges (electrons and holes) generated in the light emitting areas adjacent to each other are transferred to the light emitting areas adjacent to each other may be reduced.

The light blocking layer BM may be disposed on the encapsulation layer TFEL. The light blocking layer BM may include a plurality of pattern openings OPX1, OPX2, and OPX3 disposed to overlap the plurality of pixel openings POP1, POP2, and POP3. The plurality of pattern openings OPX1, OPX2, and OPX3 may be disposed between the light emitting areas EA1, EA2, and EA3 and may be disposed to overlap the light blocking layer BM. For example, a first pattern opening OPX1 may be disposed to overlap the first pixel opening POP1. A second pattern opening OPX2 may be disposed to overlap the second pixel opening POP2, and a third pattern opening OPX3 may be disposed to overlap the third pixel opening POP3.

An area or size of each of the pattern openings OPX1, OPX2, and OPX3 may be the same as that of each of the pixel openings POP1, POP2, and POP3. For example, the area or size of the first pattern opening OPX1 may be the same as the area or size of the first pixel opening POP1, the area or size of the second pattern opening OPX2 may be the same as the area or size of the second pixel opening POP2, and the area or size of the third pattern opening OPX3 may be the same as the area or size of the third pixel opening POP3.

In some embodiments, the area or size of each of the pattern openings OPX1, OPX2, and OPX3 may be greater than that of each of the pixel openings POP1, POP2, and POP3. In addition, in some embodiments, the area or size of each of the pattern openings OPX1, OPX2, and OPX3 may be smaller than that of each of the pixel openings POP1, POP2, and POP3.

As described above, in the display device 10 according to an embodiment, the leakage current may be reduced by forming the pixel openings POP1, POP2, and POP3 formed in the pixel defining layer PDL and the second passivation layer PAS2 between the light emitting areas EA1, EA2, and EA3. In addition, the unnecessary metal oxide layer USL may be omitted by forming the pattern openings OPX1, OPX2, and OPX3 of the metal oxide layer USL overlapping the pixel openings POP1, POP2, and POP3.

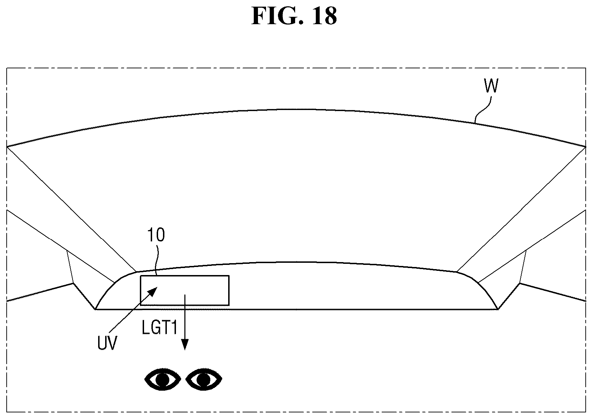

FIG. 18 is a schematic view when the display device according to an embodiment is applied to a vehicle.

Referring to FIG. 18, the display device 10 according to an embodiment may be, for example, a display device applied to a vehicle. The vehicle may include a body forming an exterior of the vehicle and an interior space defined by the body. The body may include a windshield W that protects a driver and passengers from the outside and provides visibility to the driver. As illustrated in FIG. 18, the display device 10 may be provided in the interior space.

In an embodiment, the display device 10 may be disposed on a dashboard provided in the interior space. For example, the display device 10 may be disposed on the dashboard in front of a driver's seat to provide speed information to the driver, or may be disposed on the dashboard in front of a passenger's seat to provide entertainment information to the passenger, or may be disposed at the center of the dashboard to provide map information and the like. FIG. 18 illustratively illustrates the display device 10 disposed on the dashboard in front of the driver's seat and the driver viewing a display screen of the display device 10. The driver may recognize (or visually recognize) the display screen of the display device 10 through light LGT1 emitted from the display device 10 towards the driver.

Among lights incident from the outside or inside of the vehicle, light (UV) in an ultraviolet wavelength band may be incident to the display device 10. As the display device 10 includes the metal oxide layer USL overlapping the pixel defining layer PDL as illustrated in FIGS. 5 to 17 described above, it is possible to block light (UV) in the ultraviolet wavelength band incident from the outside from being incident on the pixel defining layer PDL. Accordingly, deterioration of the organic layer EL and oxidation of the common electrode CE due to out-gassing of the pixel defining layer PDL may be reduced, thereby reducing a pixel shrinkage phenomenon.

Although the embodiments of the present invention have been described above with reference to the accompanying drawings, it will be understood by those of ordinary skill in the art to which the present invention pertains that the present invention may be embodied in other specific forms without changing the technical spirit or essential characteristics of the present invention. Therefore, the embodiments described above are to be understood as illustrative in all respects and not restrictive.

## Claims

1. A display device for a vehicle, the display device comprising:
a substrate;
a light emitting element layer disposed on the substrate and including a pixel electrode, an organic layer, and a common electrode;
a pixel defining layer disposed on the substrate and including a plurality of openings exposing a portion of the pixel electrode;
an encapsulation layer disposed on the light emitting element layer;
a metal oxide layer disposed on the encapsulation layer and overlapping the pixel defining layer;
a light blocking layer disposed on the metal oxide layer and overlapping the metal oxide layer; and
a color filter layer disposed on the light blocking layer and the encapsulation layer.

2. The display device of claim 1, wherein the metal oxide layer is in contact with an upper surface of the encapsulation layer and a lower surface of the light blocking layer.

3. The display device of claim 1, wherein the metal oxide layer includes any one or more selected from titanium oxide, zinc oxide, and tantalum oxide.

4. The display device of claim 1, wherein the metal oxide layer has a thickness of 10 to 10000 nm.

5. The display device of claim 1, wherein the metal oxide layer includes a plurality of opening holes overlapping the plurality of openings.

6. The display device of claim 5, wherein a size of the opening hole of the metal oxide layer is the same as a size of the opening of the pixel defining layer.

7. The display device of claim 5, wherein a size of the opening hole of the metal oxide layer is greater than a size of the opening of the pixel defining layer, and a width of the metal oxide layer is smaller than a width of the pixel defining layer.

8. The display device of claim 7, wherein a side of the metal oxide layer is disposed inward more than a side of the light blocking layer, and the light blocking layer covers an upper surface and the side of the metal oxide layer.

9. The display device of claim 7, wherein the light blocking layer includes a plurality of holes overlapping the plurality of openings, and the size of the opening hole of the metal oxide layer is greater than a size of the hole of the light blocking layer.

10. The display device of claim 5, wherein the light blocking layer includes a plurality of holes overlapping the plurality of openings, and the size of the opening hole of the metal oxide layer is smaller than a size of the hole of the light blocking layer.

11. The display device of claim 10, wherein a side of the metal oxide layer protrudes outward more than a side of the light blocking layer, and a width of the metal oxide layer is greater than a width of the light blocking layer.

12. The display device of claim 5, wherein the light blocking layer includes a plurality of holes overlapping the plurality of openings, and the size of the opening hole of the metal oxide layer is the same as a size of the hole of the light blocking layer.

13. The display device of claim 12, wherein a side of the metal oxide layer is aligned and matched with a side of the light blocking layer.

14. The display device of claim 1, wherein the pixel defining layer includes a plurality of pixel openings disposed between the pixel electrodes, and the light blocking layer includes a plurality of pattern openings overlapping the plurality of pixel openings.

15. The display device of claim 1, wherein a side of the metal oxide layer is aligned and matched with a side of the pixel defining layer, and a width of the metal oxide layer is the same as a width of the pixel defining layer.

16. A vehicle including a dashboard and a display device for a vehicle that is disposed on the dashboard to display information, wherein the display device for a vehicle includes:
a substrate;
a light emitting element layer disposed on the substrate and including a pixel electrode, an organic layer, and a common electrode;
a pixel defining layer disposed on the substrate and including a plurality of openings exposing a portion of the pixel electrode;
an encapsulation layer disposed on the light emitting element layer;
a metal oxide layer disposed in the encapsulation layer and overlapping the pixel defining layer;
a light blocking layer disposed on the encapsulation layer and overlapping the metal oxide layer; and
a color filter layer disposed on the light blocking layer and the encapsulation layer.

17. The vehicle of claim 16, wherein the encapsulation layer includes a first encapsulation layer disposed on the light emitting element layer, a second encapsulation layer disposed on the first encapsulation layer, and a third encapsulation layer disposed on the second encapsulation layer.

18. The vehicle of claim 17, wherein the metal oxide layer is disposed between the second encapsulation layer and the third encapsulation layer.

19. The vehicle of claim 17, wherein the metal oxide layer is disposed between the first encapsulation layer and the second encapsulation layer.

20. The vehicle of claim 16, wherein the metal oxide layer includes any one or more selected from titanium oxide, zinc oxide, and tantalum oxide.
